# EUROPÄISCHE PATENTSCHRIFT

(11) **EP 3 126 851 B1**
(45) Veröffentlichungstag und Bekanntmachung des Hinweises auf die Patenterteilung: **12.06.2019**
(21) Anmeldenummer: 15713895.9
(22) Anmeldetag: 02.04.2015
(51) Int. Cl.: G01R 1/04, G01R 3/00, G01R 1/073, H01R 12/71, H01R 12/91, H05K 3/12, H05K 3/46, H05K 1/16, H05K 1/11, G01R 1/067, H01L 21/67, G01R 31/28

(54) **KONTAKT-ABSTANDSTRANSFORMER, ELEKTRISCHE PRÜFEINRICHTUNG SOWIE VERFAHREN ZUR HERSTELLUNG EINES KONTAKT-ABSTANDSTRANSFORMERS**
CONTACT INTERPOSER, ELECTRICAL TESTING DEVICE AND MANUFACTURING METHOD FOR A CONTACT INTERPOSER
INTERCALAIRE DE CONTACT, DISPOSITIF DE TEST ÉLECTRIQUE ET PROCÉDÉ DE FABRICATION D'UN INTERCALAIRE DE CONTACT

(30) Priorität: 04.04.2014 DE 102014004942
(43) Veröffentlichungstag der Anmeldung: 08.02.2017
(73) Patentinhaber: Feinmetall GmbH, 71083 Herrenberg (DE)
(72) Erfinder: EKIN, Cetin, 72218 Wildberg (DE)
(74) Vertreter: Clarenbach, Carl-Philipp
(86) Internationale Anmeldenummer: PCT/EP2015/057386
(87) Internationale Veröffentlichungsnummer: WO 2015/150548

(56) Entgegenhaltungen:
- CN-A- 103 327 741
- DE-A1- 10 050 077
- US-A1- 2005 156 611
- US-A1- 2008 061 808
- US-A1- 2013 170 171

## Beschreibung

Die Erfindung betrifft einen Kontakt-Abstandstransformer einer elektrischen Prüfeinrichtung zur Prüfung eines elektrischen Prüflings, insbesondere Wafers. Ferner betrifft die Erfindung eine elektrische Prüfeinrichtung zur Prüfung eines elektrischen Prüflings, insbesondere Wafers, mit einem Kontakt-Abstandstransformer. Schließlich betrifft die Erfindung ein Verfahren zur Herstellung eines Kontakt-Abstandstransformers einer elektrischen Prüfeinrichtung zur Prüfung eines elektrischen Prüflings, insbesondere Wafers.

Aus der Offenlegungsschrift DE 100 50 077 A1 ist eine Anschlussstruktur zur Herstellung einer elektrischen Verbindung mit einem Zielanschluss bekannt. Die Anschlussstruktur weist eine Vielzahl von Anschlusselementen auf, von denen jede einen balkenförmigen Anschlussbereich umfasst, der eine Federkraft ausübt, wenn eine Spitze des Anschlusselements gegen den Zielanschluss gepresst wird. Aus der Druckschrift EP 1 716 421 A2 geht eine Prüfkartenanordnung zum Testen eines elektronischen Bauteils hervor, aus der Offenlegungsschrift US 2008 / 061808 A1 ist eine Prüfkarte zum Testen eines elektronischen Bauteils bekannt. Das Druckschrift CN 103 327 741 A beschreibt ein 3D-Print-basiertes Substrat und ein Herstellungsverfahren davon. Die Offenlegungsschrift US 2013 / 170171 A1 betrifft ein Verfahren zum Herstellen eines dreidimensionalen elektronischen Bauteils.

Der erfindungsgemäße Kontakt-Abstandstransformer gehört einer elektrischen Prüfeinrichtung zur Prüfung eines elektrischen Prüflings, insbesondere Wafers, an. Diese elektrische Prüfeinrichtung, die ebenfalls Gegenstand der Erfindung ist, weist vorzugsweise ein Leitersubstrat, insbesondere eine Leiterplatte (PCB) auf, das/die bevorzugt mit Leiterbahnen versehen ist. Die Leiterbahnen führen auf einer Seite des Leitersubstrats insbesondere über Kabel zu einer Testeinrichtung (Tester). Auf der anderen Seite des Leitersubstrats liegen mit den Leiterbahnen verbundene Kontaktflächen, die über ein Verbindungsbauteil (Interposer) mit dem hier genannten Kontakt-Abstandstransformer elektrisch verbunden sind. Diese Verbindung erfolgt durch Berührungskontaktieren. Der Kontakt-Abstandstransformer setzt die Kontaktabstände des Leitersubstrats auf ein erheblich kleineres Maß um, d.h., der Kontakt-Abstandstransformer stellt Kontakte mit sehr geringem Abstand zur Verfügung, vorzugsweise einem Abstand der dem Kontaktabstand des Prüflings entspricht. Über einen Kontaktkopf, der vorzugsweise mindestens zwei beabstandet zueinander liegende, mit Führungsbohrungen versehene Führungsplatten aufweist, wobei in den Führungsbohrungen Knickkontaktnadeln lagern, werden die engliegenden Kontakte des Kontakt-Abstandstransformer in Berührungskontaktierung mit dem Prüfling verbunden. Mittels des Testers können somit Stromwege geschaltet werden, um die elektrische Funktionsfähigkeit des Prüflings zu testen. Neben dem vorstehend erläuterten Aufbau einer elektrischen Prüfeinrichtung umfasst die Erfindung auch andere Aufbauten, auf die nachstehend eingegangen wird. Die einzelnen, erwähnten Bauglieder, wie Leitersubstrat, Verbindungsbauteil, Kontakt-Abstandstransformer, Kontaktkopf und so weiter sind bei bekannten Prüfeinrichtungen in konventioneller Bauart erstellt.

Der Erfindung liegt die Aufgabe zugrunde, mindestens ein Bauglied einer Prüfeinrichtung, insbesondere einen Kontakt-Abstandstransformer, anzugeben, das/der einfach aufgebaut und preiswert ist, insbesondere auch in sehr kurzer Zeit hergestellt werden kann. Gegenüber einem bekannten Kontakt-Abstandstransformer, der aus mehrlagiger Keramik aufgebaut ist, wobei die Keramik mit Leiterbahnen versehene Keramikplatten aufweist und derartige Keramikplatten Lage um Lage aufeinandergestapelt und zusammengepresst und dabei gesindert werden, soll also ein wesentlich einfacher und kostengünstiger aufgebautes Bauglied geschaffen werden. Ferner soll auch eine entsprechend einfache und kostengünstig aufgebaute elektrische Prüfeinrichtung geschaffen werden sowie ein Verfahren, um zu derartigen erfindungsgemäßen Kontakt-Abstandstransformern (Spacetransformern) beziehungsweise Prüfeinrichtungen zu gelangen.

Diese Aufgabe wird bei einem Kontakt-Abstandstransformer einer elektrischen Prüfeinrichtung zur Prüfung eines elektrischen Prüflings, insbesondere Wafers, dadurch gelöst, dass der Kontakt-Abstandstransformer zur Abstandsverkleinerung von benachbart zueinander liegenden elektrischen Kontakten eine elektrisch nichtleitende Tragstruktur aufweist, die eine erste Seite und eine zweite Seite besitzt, wobei auf der ersten Seite erste elektrische Kontakte mit einem Kontaktabstand zueinander liegen und auf der zweiten Seite zweite elektrische Kontakte angeordnet sind, die einen gegenüber den ersten Kontakten der ersten Seite kleineren Kontaktabstand zueinander aufweisen, wobei die ersten Kontakte mit den zweiten Kontakten mittels die Tragstruktur durchsetzenden und/oder auf der Tragstruktur angeordneten elektrischen Verbindungen verbunden sind, wobei sowohl die Tragstruktur als auch die elektrischen Verbindungen als 3D-Druckbauteile ausgebildet sind. Demzufolge sind die Tragstruktur und die elektrischen Verbindungen im 3D-Drucker-Fügeverfahren erstellt. Da die Tragstruktur elektrisch nichtleitend ausgebildet ist, wird für den 3D-Druck elektrisch isolierendes Druckmaterial verwendet. Für die elektrischen Verbindungen wird dementsprechend beim 3D-Druck elektrisch leitendes Druckmaterial eingesetzt. Beim 3D-Druck werden die genannten Druckmaterialien vorzugsweise mit entsprechenden Dosierköpfen appliziert. Entsprechend einem 3D-Drucker fahren die Dosierköpfe, in denen sich das zugehörige Fügematerial (Druckmaterial) befindet, an entsprechende Positionen und dabei/dann wird das Druckmaterial ausgestoßen, sodass es - verfestigt - entsprechende Teile der Tragstruktur beziehungsweise der elektrischen Verbindungen aufbaut. Dabei wird vorzugsweise schrittweise vorgegangen, wenn beispielsweise auf einem Tragstrukturbereich ein elektrischer Verbindungsbereich aufgetragen werden soll, so ist der Tragstrukturbereich Voraussetzung für die darauf erfolgende Erzeugung des elektrischen Verbindungsbereichs, sodass zunächst dieser Tragstrukturbereich gedruckt werden muss und erst danach der elektrischen Verbindungsbereich. Vorzugsweise können dieselben und/oder die verschiedenen Druckmaterialien schichtweise aufgetragen werden. Selbstverständlich ist es möglich, dass im Zuge des 3D-Druckverfahrens Versteifungselemente zugeführt und "umdruckt" werden, um der Gesamtanordnung eine höhere Festigkeit zu verleihen. Überdies können, vorzugsweise ebenfalls im 3D-Druck, Klebstoffe, insbesondere leitfähige Klebstoffe, und Füllstoffe, insbesondere isolierende Füllstoffe, zugeführt, also gedruckt werden. Aufgrund der Erfindung lässt sich demzufolge ein Kontakt-Abstandstransformer im 3D-Druckverfahren erstellen, was sehr kostengünstig ist und zur schnellen Verfügbarkeit des fertigen Produktes führt. Komplizierteste Strukturen der elektrischen Verbindungen lassen sich flächig und räumlich auf und/oder in der Tragstruktur erstellen. Der 3D-Druck ermöglicht es, die elektrischen Verbindungen auf der zweiten Seite der nichtleitenden Tragstruktur gegenüber deren Anordnung auf der ersten Seite derart stark zu "bündeln", dass die gewünschte Kontakt-Abstandsverkleinerung erzielt wird.

Nach einer Weiterbildung der Erfindung ist vorgesehen, dass die ersten und/oder die zweiten Kontakte ebenfalls als 3D-Druckbauteile ausgebildet sind. Diese an der ersten beziehungsweise an der zweiten Seite der Tragstruktur liegenden Kontakte können vorzugsweise mit dem gleichen Druckmaterial und dem gleichen Dosierkopf erstellt werden, wie auch die elektrischen Verbindungen.

Nach einer Weiterbildung der Erfindung ist vorgesehen, dass mindestens ein erster und/oder mindestens ein zweiter Kontakt durch die Stirnfläche mindestens einer der elektrischen Verbindungen gebildet ist. Die Kontakte sind insofern nicht gestalterisch unterschiedlich zu den zugehörigen Verbindungen, sondern die jeweilige Verbindung verläuft bis an die erste oder zweite Seite der Tragstruktur, sodass von außen betrachtet nur die Stirnfläche dieser Verbindung ersichtlich ist, wobei diese Stirnfläche den entsprechenden Kontakt bildet.

Besonders vorteilhaft ist es, wenn der Kontakt-Abstandstransformer nur aus 3D-Druckbauteilen besteht. Demzufolge wird er komplett im 3D-Druckverfahren erstellt.

Nach einer Weiterbildung der Erfindung ist vorgesehen, dass der Kontakt-Abstandstransformer mindestens ein elektrisches Bauelement, insbesondere einen Widerstand, eine Spule und/oder einen Kondensator, aufweist, wobei das Bauelement ebenfalls als 3D-Druckbauteil ausgebildet ist. Diese verschiedenen Bauelemente werden demgemäß während des 3D-Drucks des Kontakt-Abstandstransformers miterzeugt. Hierzu ist ein Dosierkopf vorhanden, der beispielsweise ein Druckmaterial enthält, das als Widerstandsmaterial für einen elektrischen Widerstand verwendet werden kann. Spulen werden dadurch erzeugt, dass ein Druckkopf eine spiralförmige Druckbahn herstellt und elektrisch leitfähiges Druckmaterial verwendet wird. Kondensatoren lassen sich im 3D-Druck dadurch erzeugen, dass einander gegenüberstehende Leiter/Elektroden gedruckt werden. Hierbei kann zwischen die Leiter/Elektroden wiederum ein elektrisch nichtleitendes Druckmaterial mittels eines entsprechenden Dosierkopfes aufgetragen werden, wobei das Druckmaterial bevorzugt eine gewünschte Dielektrizitätskonstante aufweist.

Vorzugsweise ist vorgesehen, dass das mindestens eine elektrische Bauelement an mindestens einem der ersten Kontakte, einem der zweiten Kontakte und/oder einer der Verbindungen durch eine elektrisch leitfähige 3D-Druckkontaktstelle elektrisch angeschlossen ist.

Um eine Hybridbauweise, bevorzugt eine Sandwichbauweise, bei dem Kontakt-Abstandstransformer zu realisieren, ist bevorzugt auf der ersten Seite und/oder der zweiten Seite ein Abschlusselement, insbesondere eine Abschlussplatte, bevorzugt eine Keramikplatte, angeordnet, insbesondere befestigt, wobei das Abschlusselement kein 3D-Druckbauteil ist. Bevorzugt können zwei Keramikplatten vorgesehen sein, zwischen denen der im 3D-Druck erzeugte Bereich des Kontakt-Abstandstransformers liegt, wobei die beiden Keramikplatten mit Durchgangskontakten, insbesondere Durchkontaktierungen, versehen sind, die mit den ersten beziehungsweise zweiten Kontakten elektrisch verbunden sind. Die Durchgangskontaktanordnung der einen Keramikplatte weist einen der ersten Kontakte entsprechenden Kontaktabstand auf und der Kontaktabstand der Durchgangskontakte, insbesondere Durchkontaktierungen, der anderen Keramikplatte ist entsprechend kleiner gewählt (wie der der zweiten Kontakte), um die Kontaktabstandsumsetzung (Spacetransformerfunktion) zu erzielen.

Die Erfindung betrifft ferner eine elektrische Prüfeinrichtung zur Prüfung eines elektrischen Prüflings, insbesondere Wafers, wobei ein Kontakt-Abstandstransformer verwendet wird, der entsprechend mindestens einer der vorstehend genannten Ausführungen ausgestaltet ist.

Nach einer Weiterbildung der elektrischen Prüfeinrichtung ist vorgesehen, dass diese ein Leitersubstrat mit Kontaktflächen besitzt, die mit den ersten Kontakten des Kontakt-Abstandstransformers direkt oder über ein elektrisches Verbindungsbauteil in elektrischer Verbindung, bevorzugt elektrischer Berührungsverbindung, steht. Das Verbindungsbauteil ist vorzugsweise in konventioneller Technik, also nicht in 3D-Drucktechnik erstellt.

Bevorzugt weist das Verbindungsbauteil eine mit Kontaktfedern bestückte Folie auf. Mittels der Kontaktfedern werden einerseits die Kontaktflächen des Leitersubstrats berührungskontaktiert und andererseits die ersten Kontakte des 3D-Druck-Kontakt-Abstandstransformers.

Nach einer Weiterbildung der elektrischen Prüfeinrichtung ist ein Kontaktkopf vorgesehen, der Kontaktbauteile für eine elektrische Berührungskontaktierung des Prüflings aufweist. Die Anordnung ist dabei vorzugsweise derart getroffen, dass das Leitersubstrat, insbesondere wie vorstehend beschrieben, mit dem Kontakt-Abstandstransformer in elektrischer Verbindung steht und dass der Kontakt-Abstandstransformer in elektrischer Verbindung mit der einen Seite des Kontaktkopfs, insbesondere mit den Kontaktbauteilen des Kontaktkopfs in elektrischer Verbindung steht, wobei der Kontaktkopf eine elektrische Berührungskontaktierung mit Kontakten des Prüflings vornimmt. Diese elektrische Berührungskontaktierung wird bevorzugt von den Kontaktbauteilen des Kontaktkopfs vorgenommen.

Vorzugsweise ist bei der elektrischen Prüfeinrichtung vorgesehen, dass die Kontaktbauteile als Knickkontaktnadeln, Federkontaktstifte, Pogos oder dergleichen ausgebildet sind. Die Knickkontaktnadeln können sich bei der Kontaktierung elastisch durchbiegen, also seitlich ausknicken. Die Federkontaktstifte können insbesondere derart ausgebildet sein, dass sie ein federkraftbeaufschlagtes Kontaktelement besitzen, beispielsweise einen in einer Hülse verschieblich gelagerten Kolben, der eine Kontaktspitze aufweist, wobei der Kolben von einer Feder, insbesondere Schraubendruckfeder beaufschlagt wird. Die als Pogos bezeichneten Kontaktbauteile sind ebenfalls federnde Kontakte, insbesondere Federkontaktstifte, wobei der Begriff "Pogos" insbesondere in den USA Verwendung findet.

Ferner weist die elektrische Prüfeinrichtung - nach einer Weiterbildung der Erfindung - bevorzugt den Kontaktkopf auf, der mindestens zwei beabstandet zueinander liegende, mit Führungsbohrungen versehene Führungsplatten besitzt, wobei in den Führungsbohrungen die Kontaktbauteile, insbesondere Knickkontaktnadeln, für eine elektrischen Berührungskontaktierung des Prüflings liegen/lagern. Die insbesondere vorgesehenen Knickkontaktnadeln können bei der Kontaktierung des Prüflings seitlich ausfedern, wodurch eine sichere Kontaktierung gewährleistet ist. Der Kontaktkopf ist in konventioneller Technik hergestellt. Die Knickkontaktnadeln sind in den Führungsbohrungen der Führungsplatten längsverschieblich gelagert, um eine gute Kontaktierung einerseits zu dem Kontakt-Abstandstransformer und andererseits zu dem Prüfling zu erzielen.

Eine Weiterbildung der Erfindung sieht vor, dass die Kontaktbauteile, insbesondere Knickkontaktnadeln, mit ihren einen Enden in Berührungskontakt mit den zweiten Kontakten des Kontakt-Abstandstransformers stehen. Hierauf wurde vorstehend bereits eingegangen.

Eine Weiterbildung der Erfindung sieht vor, dass der Kontakt-Abstandstransformer das Leitersubstrat mitausbildet. Demzufolge ist Leitersubstrat und Kontakt-Abstandstransformer in einem Bauteil zusammengefasst, wobei das gesamte Bauteil im 3D-Druck erstellt ist.

Bevorzugt kann vorgesehen sein, dass die zweiten Kontakte des Kontakt-Abstandstransformers im 3D-Druck gedruckte, insbesondere erhaben gedruckte Kontaktelemente zum direkten Berührungskontaktieren des Prüflings sind. Bei dieser Ausführungsform benötigt die Prüfeinrichtung demzufolge keinen Kontaktkopf.

Bevorzugt kann ferner vorgesehen sein, dass die Kontaktelemente als punktförmige Kontakte, in Berührungskontaktierungsrichtung stiftförmige Kontakte oder größtenteils quer zur Berührungskontaktierungsrichtung verlaufende Kontakte, insbesondere Cantilever-Kontakte, ausgebildet sind. Die punktförmigen Kontakte sind hinsichtlich ihrer Form etwa ebenso lang wie breit ausgebildet. Die in Berührungskontaktierungsrichtung stiftförmigen Kontakte haben in Berührungskontaktierungsrichtung eine größere Ausdehnung als quer dazu. Die größtenteils quer zu ihrer Berührungskontaktierungsrichtung verlaufenden Kontakte, insbesondere Cantilever-Kontakte, sind derart gestaltet, dass sie einen Abschnitt aufweisen, der quer zur Berührungskontaktierungsrichtung verläuft, wobei unter quer sowohl schräg, als auch rechtwinklig zu verstehen ist. Ferner weisen sie vorzugsweise einen von diesem quer verlaufenden Abschnitt abgewinkelt verlaufenden Bereich auf, mit dem die Berührungskontaktierung des Prüflings erfolgt. Insbesondere der quer verlaufende Abschnitt führt zu einer Federwirkung, also einem elastischen Nachgeben bei der Berührungskontaktierung.

Die Erfindung betrifft ferner ein Verfahren zur Herstellung eines Kontakt-Abstandstransformers einer elektrischen Prüfeinrichtung zur Prüfung eines elektrischen Prüflings, insbesondere Wafers, wobei der Kontakt-Abstandstransformer insbesondere gemäß einer der vorstehenden Ausführungen ausgebildet ist/wird, wobei folgende Schritte vorgesehen sind: 3D-Drucken, insbesondere schichtweises 3D-Drucken, von einer Tragstruktur aus elektrisch isolierendem Druckmaterial sowie 3D-Drucken, insbesondere schichtweises 3D-Drucken, von die Tragstruktur durchsetzenden und/oder auf der Tragstruktur angeordneten elektrischen Verbindungen aus elektrisch leitfähigem Druckmaterial.

Insbesondere kann ein 3D-Drucken, insbesondere schichtweises 3D-Drucken, von ersten und/oder zweiten Kontakten aus elektrisch leitfähigem Druckmaterial erfolgen, wobei die ersten und/oder zweiten Kontakte an mindestens einem der Enden der elektrischen Verbindungen angeordnet werden. Sofern die ersten und/oder zweiten Kontakte nicht separat von den elektrischen Verbindungen ausgestaltet werden, sondern die elektrischen Verbindungen durch ihre Stirnflächen beziehungsweise Endbereiche die ersten und/oder zweiten Kontakte bilden, werden diese Kontakte bereits mit der Erstellung der elektrischen Verbindungen erzeugt.

Insbesondere kann vorgesehen sein, dass ein 3D-Drucken, insbesondere schichtweises 3D-Drucken, erfolgt, um mittels elektrisch leitfähigem Druckmaterial auf zuvor 3D-gedruckten, elektrisch isolierendem Druckmaterial, bevorzugt elektrische Querverbindungen oder dergleichen, auch Diagonalverbindungen und so weiter, herzustellen.

Eine Weiterbildung des erfindungsgemäßen Verfahrens sieht ein 3D-Drucken vor, insbesondere ein schichtweises 3D-Drucken, um mittels elektrisch weniger leitfähigem Druckmaterial mindestens einen elektrischen Widerstand herzustellen. Derartige Widerstände liegen somit insbesondere im Innern des Kontakt-Abstandstransformers, vorzugsweise eingebettet in die 3D-gedruckte Tragstruktur. Entsprechendes gilt für den nachstehend erwähnten Kondensator beziehungsweise die nachstehend erwähnte Spule.

Bevorzugt erfolgt ein 3D-Drucken, insbesondere schichtweises 3D-Drucken, von sich gegenüberliegenden Elektroden aus elektrisch leitfähigem Druckmaterial zur Herstellung eines Kondensators, wobei vorzugsweise ein 3D-Druck von Dielektrikummaterial zwischen die Elektroden erfolgt.

Ferner ist bevorzugt ein 3D-Drucken, insbesondere schichtweises 3D-Drucken, von spiralförmigen und/oder schneckenförmigen und/oder wendelförmigen Leitern aus elektrisch leitfähigem Material zur Herstellung von mindestens einer Spule vorgesehen.

Ferner ist das erfindungsgemäße Verfahren gekennzeichnet durch 3D-Drucken, insbesondere schichtweises 3D-Drucken, von flüssiger, sich unter Schwerkrafteinwirkung verteilender und danach aushärtender Isolierflüssigkeit zur Herstellung von elektrischen Isolierbereichen, insbesondere von Isolationsschichten. Hierbei handelt es sich bevorzugt um die Tragstruktur beziehungsweise Teile der Tragstruktur. Entsprechend kann auch elektrisch leitfähige Flüssigkeit gedruckt werden.

Ferner kann bevorzugt vorgesehen sein, mittels 3D-Druck Kleb- und/oder Füllstoffe bei der Erstellung des Kontakt-Abstandstransformers oder der elektrischen Prüfeinrichtung beziehungsweise bei der Durchführung des erwähnten Verfahrens vorzusehen. Die Klebstoffe können elektrisch leitfähig oder elektrisch nicht leitfähig sein. Entsprechendes gilt für die Füllstoffe.

Die Zeichnungen veranschaulichen die Erfindung anhand von Ausführungsbeispielen und zwar zeigt:
- Figur 1: eine schematische Darstellung einer Prüfeinrichtung zur Prüfung eines elektrischen Prüflings,
- Figur 2a: einen 3D-Druckvorgang,
- Figur 2b: eine Ausschnittvergrößerung aus Figur 2a,
- Figuren 3 bis 5: weitere 3D-Druckvorgänge,
- Figur 6: eine schematische Querschnittsansicht durch einen Kontakt-Abstandstransformer,
- Figur 7: eine Prüfeinrichtung nach einem weiteren Ausführungsbeispiel,
- Figur 8: eine Prüfeinrichtung nach einem weiteren Ausführungsbeispiel und
- Figur 9: eine Prüfeinrichtung nach einem letzten Ausführungsbeispiel.

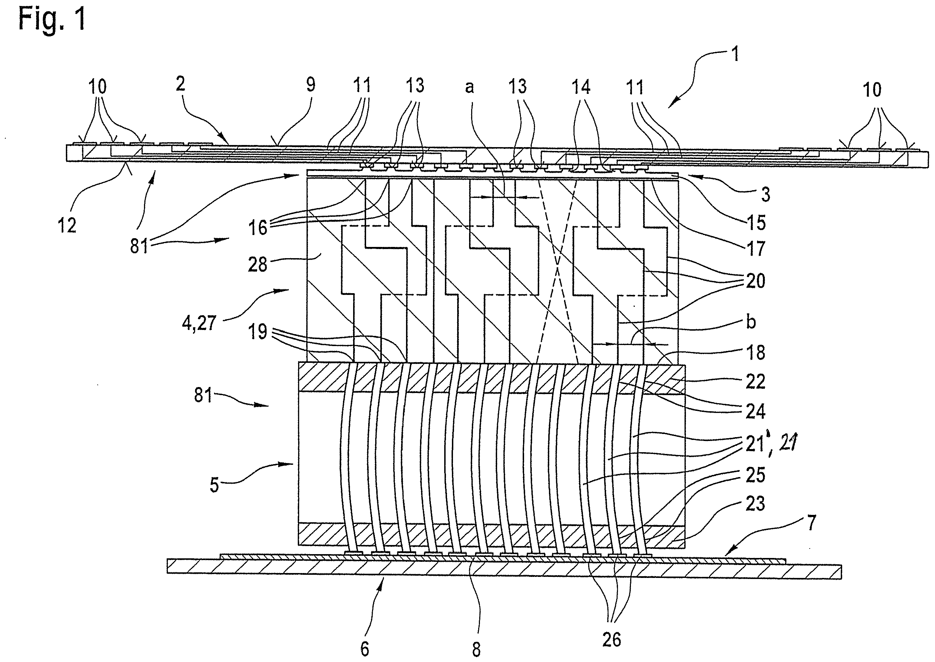

Die Figur 1 zeigt eine Prüfeinrichtung 1 in schematischer Darstellung, die ein Leitersubstrat 2, ein elektrisches Verbindungsbauteil 3, einen Kontakt-Abstandstransformer 4 und einen Kontaktkopf 5 aufweist. Ferner kann die Prüfeinrichtung 1 einen Aufnahmetisch 6 für einen auf elektrische Funktionsfähigkeit zu prüfenden Prüfling 7 aufweisen, wobei der Prüfling 7 insbesondere als Wafer 8 ausgebildet sein kann.

Das Leitersubstrat 2, das insbesondere als mehrlagige Leiterplatte ausgebildet ist, weist auf seiner Oberseite 9 außenrandseitig liegende Kontaktflächen 10 auf, die über Leiterbahnen 11 mit an seiner Unterseite 12 liegenden Kontaktflächen 13 elektrisch verbunden sind. Die Kontaktflächen 13 stehen in Berührungskontaktierung mit Kontaktfedern 14 des Verbindungsbauteils 3. Das Verbindungsbauteil 3 weist eine Folie 15 auf, die Kontaktfedern 14 trägt. Die Kontaktfedern 14 stehen in Berührungskontaktierung mit ersten Kontakten 16 des Kontakt-Abstandstransformers 4. Die ersten Kontakte 16 befinden sich an einer ersten Seite 17 des Kontakt-Abstandstransformers 4. An einer zweiten Seite 18 des Kontakt-Abstandstransformers 4, die vorzugsweise der ersten Seite 17 planparallel gegenüberliegt, befinden sich zweite Kontakte 19 des Kontakt-Abstandstransformers 4, wobei die ersten Kontakte 16 mit den zweiten Kontakten 19 über elektrische Verbindungen 20 verbunden sind. Dabei können, entsprechend der Prüfung des Prüflings 7 komplizierte Verlaufsstrukturen der elektrischen Verbindungen 20 vorliegen, um entsprechende erste Kontakte 16 mit entsprechenden zweiten Kontakten 19 zu verbinden. Überdies ist vorgesehen, dass benachbart zueinander liegende erste Kontakte 16 einen Kontaktabstand a aufweisen und das benachbart zueinander liegende zweite Kontakte 19 einen Kontaktabstand b aufweisen. Die Anordnung ist nun so getroffen, dass der Kontaktabstand b sehr viel kleiner ist als der Kontaktabstand a, was - aus zeichentechnischen Gründen - jedoch nicht der Figur 1 entnommen werden kann. Die zweiten Kontakte 19 des Kontakt-Abstandstransformers 4 stehen in Berührungskontaktierung mit Kontaktbauteilen 21', insbesondere Knickkontaktnadeln 21, des Kontaktkopfs 5. Der Kontaktkopf 5 weist zwei beabstandet und vorzugsweise parallel zueinander verlaufende Führungsplatten 22 und 23 auf, die jeweils Führungsbohrungen 24 und 25 besitzen. Die Knickkontaktnadeln 21 sind längsverschieblich in den Führungsbohrungen 24 und 25 gelagert, derart, dass sie mit ihren einen Enden in Berührungskontakt mit den zweiten Kontakten 19 stehen und mit ihren anderen Enden aus der Führungsplatte 23 herausragen und somit mit Prüflingskontakten 26 des Prüflings 7 in Berührungskontakt stehen. Die Knickkontaktnadeln 21 sind - wie ihr Name sagt - geringfügig seitlich durchgebogen, um eine Federwirkung zu entfalten.

Für die Prüfung des elektrischen Prüflings 7 wird dieser mittels des Aufnahmetischs 6 angehoben und gegen die Prüfeinrichtung 1 gedrückt, wodurch die vorstehend genannten Berührungskontaktierungen der verschiedenen Bauglieder stattfindet. Über elektrische, nicht dargestellte Leitungen, die an die Kontaktflächen 10 angeschlossen sind und die zu einem Tester führen, können nun Prüfstromkreise zum Prüfling 7 geschaltet werden, um diesen auf elektrische Funktionsfähigkeit zu prüfen. Diese Prüfung erfolgt vorzugsweise auch unter Berücksichtigung eines großen Temperaturspektrums.

Die erfindungsgemäße Anordnung der Figur 1 ist nun derart getroffen, dass der Kontakt-Abstandstransformer 4 vorzugsweise vollständig als 3D-Druckbauteil 27 ausgebildet ist. Er weist eine elektrisch nicht leitende Tragstruktur 28 auf, sowie die Tragstruktur 28 durchsetzende und/oder auf der Tragstruktur 28 angeordnete elektrischen Verbindungen 20. Diese bestehen aus elektrisch leitfähigem Material. Die Tragstruktur 28 und die Verbindungen sind jeweils 3D-Druckbauteile 27.

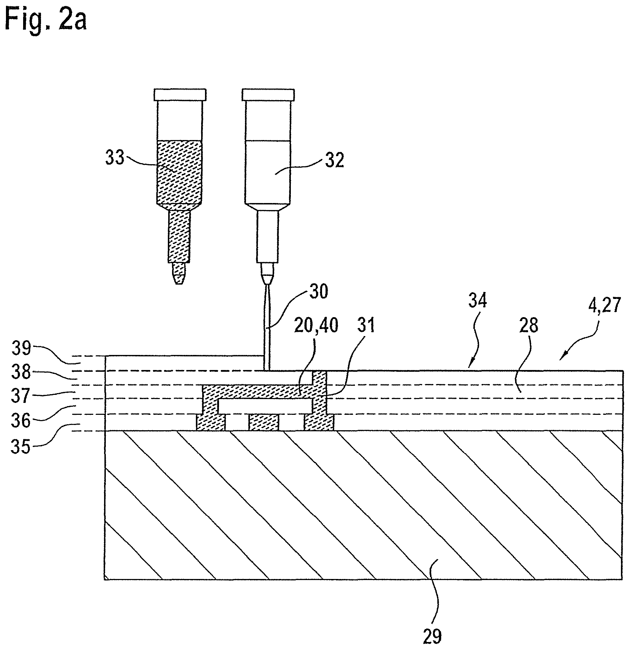

Die Figuren 2a, 2b, 3, 4 und 5 verdeutlichen den Herstellungsprozess des Kontakt-Abstandstransformers 4, der im 3D-Druckerverfahren erstellt wird. Gemäß Figur 2a wird auf eine Unterlage 29 mittels eines nicht näher dargestellten 3D-Druckers Druckmaterial 30 sowie Druckmaterial 31 insbesondere schichtweise und pro Schicht insbesondere bereichsweise aufgetragen/gedruckt. Die Druckmaterialien 30 und 31 befinden sich vorzugsweise in Dosierköpfen 32 und 33 des 3D-Druckers. Diese Dosierköpfe 32 und 33 können in entsprechende räumliche Positionen gefahren werden, um das Druckmaterial 30, 31 auszustoßen oder nicht auszustoßen. Der sich in der Figur 2a auf der Unterlage 29 befindliche Teilbereich 34 des in der Entstehung befindlichen Kontakt-Abstandstransformers 4 weist insgesamt fünf Schichten 35 bis 39 auf. Die einzelnen Schichten 35 bis 39 bestehen aus dem Druckmaterial 30 und/oder im Druckmaterial 31. Das Druckmaterial 30 ist elektrisch nicht leitend und dient zur Herstellung der Tragstruktur 28 und das Druckmaterial 33 ist elektrisch leitend und dient zur Herstellung der ersten Kontakte 16, zweiten Kontakte 19, elektrischen Verbindungen 20 und/oder Querverbindungen 40. Die Querverbindungen 40 gehören den Verbindungen 20 an. Die Verbindungen 20 durchsetzen in vorgegebenen (entsprechend der angewendeten Software für den Druckvorgang des 3D-Druckers) Bahnen horizontal, vertikal und/oder schrägverlaufend, also 3D-mäßig, die Tragstruktur 28.

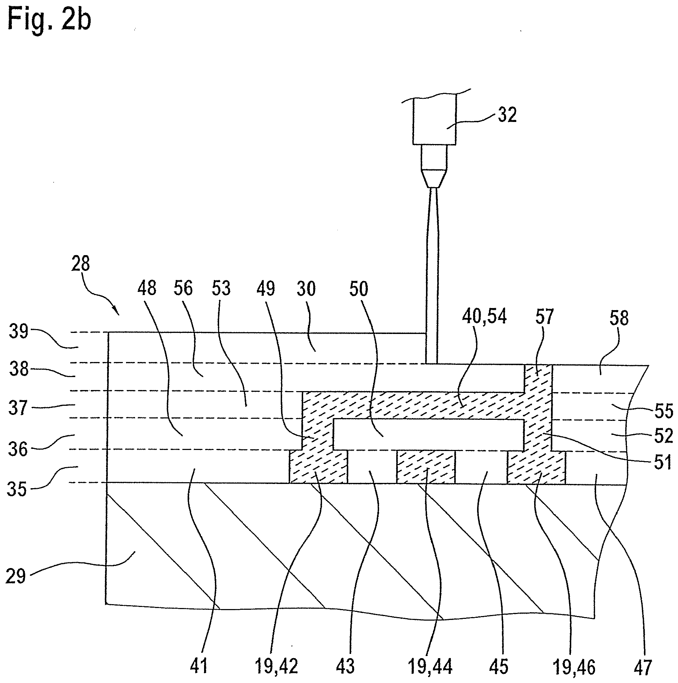

Zur Verdeutlichung des erwähnten schichtweisen und innerhalb jeder Schicht gegebenenfalls bereichsweise erfolgenden Druckens verschiedener Druckmaterialien 30, 31 wird auf die Figur 2b verwiesen, die ein Abschnitt der Figur 2a in größerem Maßstab zeigt. Mittels der Dosierköpfe 32 und 33 werden gewünschte Positionen angefahren und dabei der jeweilige Druckvorgang durchgeführt. Zur Erzeugung der Schicht 35 wird zunächst der Bereich 41 durch Auftragen von Druckmaterial 30 erzeugt. Dann wird der Druckvorgang des Dosierkopfs 32 gestoppt und mit dem Dosierkopf 33 weitergedruckt, um den Bereich 42 aus Druckmaterial 31 herzustellen. Es folgt dann in der Schicht 35 ein Bereich 43 aus Druckmaterial 30, d.h., es wird der Druckvorgang fortgesetzt mit dem Dosierkopf 32. Daran schließt sich ein Bereich 44 aus Druckmaterial 31 und dann ein Bereich 45 aus Druckmaterial 30 an. Es folgt ein Bereich 46 aus Druckmaterial 31 und dann ein Bereich 47 aus Druckmaterial 30 und so weiter. Insgesamt werden auf diese Art und Weise elektrisch nicht leitende und elektrisch leitende Bereiche erstellt, um entsprechende Abschnitte der Tragstruktur 28 beziehungsweise leitenden Struktur für die beispielsweise zweiten Kontakte 19 herzustellen. Die vorstehend erwähnte Reihenfolge der einzelnen Druckvorgänge kann natürlich auch anders erfolgen, zum Beispiel erst alle elektrisch leitenden Bereiche und dann alle elektrisch nicht leitenden Bereiche (oder umgekehrt). Auf die Schicht 35 wird dann die Schicht 36 gedruckt, die aus einem Bereich 48 aus nicht leitendem Druckmaterial 30, einem Bereich 49 aus leitendem Druckmaterial 31, einem Bereich 50 aus nicht leitendem Druckmaterial 30, einem Bereich 51 aus leitendem Druckmaterial 31 und einem Bereich 52 aus nicht leitendem Druckmaterial 30 besteht. Dabei werden die entsprechenden Bereiche der Schicht 36 auf entsprechende Bereiche der Schicht 35 gedruckt, sodass entweder der elektrisch nicht leitende Abschnitt vergrößert oder der elektrisch leitende Abschnitt vergrößert oder ein Übergang geschaffen wird von elektrisch leitend auf elektrisch nicht leitend oder umgekehrt. Im vorliegenden Falle stellt der Bereich 49 eine elektrische Verbindung 20 zu dem Bereich 42 her. Entsprechendes gilt für den Bereich 51 in Bezug auf den Bereich 46. Der Bereich 44, der elektrisch leitend ist, wird abgedeckt von dem elektrisch nicht leitenden Bereich 50. Die dritte Schicht 37, die auf die zweite Schicht 36 gedruckt wird, weist einen Bereich 53 aus elektrisch nicht leitenden Druckmaterial 30, einen Bereich 54 aus elektrisch leitendem Material 31 und einen Bereich 55 aus elektrisch nicht leitendem Druckmaterial 30 auf. Aus der Figur 2b ist ersichtlich, dass hierdurch der Bereich 49 elektrisch kontaktiert wird mit dem Bereich 54 und dieser ist wiederum elektrisch kontaktiert mit dem Bereich 51. Dabei bildet der Bereich 54 eine als Querverbindung 40 ausgebildete Verbindung 20, die elektrisch isoliert ist durch den Bereich 50 von dem Bereich 44. Die nächste Schicht 38 weist einen Bereich 56 aus elektrisch nicht leitendem Druckmaterial 30, einen Bereich 57 aus elektrisch leitendem Druckmaterial 31 und einen Bereich 58 aus elektrisch nicht leitendem Druckmaterial 30 auf. Der Bereich 57 ist elektrisch verbunden mit dem Bereich 54. Die nachfolgende Schicht 39, die sich noch in Bearbeitung befindet, besteht - wie ersichtlich - aus nicht leitendem Druckmaterial 30, das gerade von dem Dosierkopf 32 abgegeben wird. Weitere Schichten können folgen. Selbstverständlich stellen die vorstehenden Erläuterungen zu dem Druckvorgang nur Beispiele dar, aus denen jedoch klar wird, dass es möglich ist, dreidimensional zu drucken und dabei eine entsprechende Tragstruktur 28 zu schaffen sowie darin entsprechende elektrische Konturen einzubetten, um insgesamt den Kontakt-Abstandstransformer 4 zu schaffen, so wie er beispielsweise aus der Figur 1 hervorgeht. Dabei wird zur Ausbildung der Kontaktabstandsfunktion auf der einen Seite (erste Seite 17) ein großer Kontaktabstand und auf der anderen Seite (zweite Seite 18) ein kleiner, vorzugsweise sehr enger Kontaktabstand realisiert. Die aus der Figur 2b hervorgehende Unterlage 29 dient lediglich als Fertigungstisch bei der Herstellung, d.h., die gedruckte Struktur wird nach Fertigstellung des 3D-Drucks von der Unterlage 29 abgehoben.

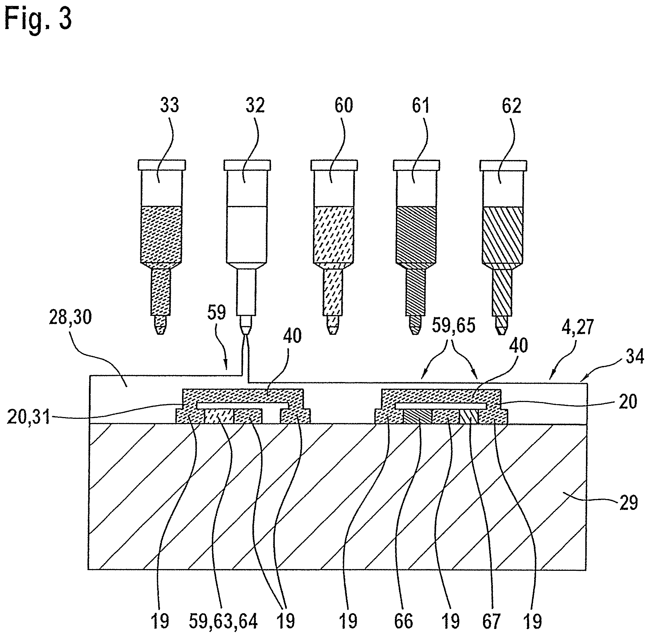

Die Figur 3 verdeutlich einen Herstellungsprozess eines Kontakt-Abstandstransformers 4, bei dem entsprechend vorgegangen wird, so wie zu den Figuren 2a und 2b beschrieben. Zusätzlich ist vorgesehen, dass während des 3D-Druckens mindestens ein elektrisches Bauelement 59 mitgedruckt wird. Hierzu weist der 3D-Drucker einerseits die bereits zuvor beschriebenen Dosierköpfe 32 und 33 auf, um elektrisch nicht leitendes Druckmaterial 30 sowie elektrisch leitendes Druckmaterial 31 zu applizieren. Ferner ist jedoch mindestens ein weiterer Dosierkopf vorhanden. In der Figur 3 sind drei weitere Dosierköpfe 60, 61 und 62 vorgesehen. Im Dosierkopf 60 befindet sich Druckmaterial von geringer elektrischer Leitfähigkeit, also einer Leitfähigkeit, um elektrische Widerstandsbahnen zu drucken. Der Dosierkopf 61 weist ein Druckmaterial mit einer Dielektrizitätskonstanten ε1 auf. Der Dosierkopf 62 weist ein Druckmaterial mit einer Dielektrizitätskonstanten ε2 auf. Wie der Figur 3 zu entnehmen ist, wurde dort ein Teilbereich eines Kontakt-Abstandstransformers 4 bereits gefertigt, der - eingebettet in nicht leitendes Druckmaterial 30 - sowohl zweite Kontakte 19 als auch elektrische Verbindungen 20 sowie Querverbindungen 40 aufweist. Im Zuge dieser Anmeldung stellen die Querverbindungen 40 eine Untergruppe der Verbindungen 20 dar. Wie bereits in der Beschreibungseinleitung erwähnt, ist es auch denkbar, dass die zweiten Kontakte 19 so gedruckt werden, dass sie sich von den räumlichen Abmessungen her von den Verbindungen 20 nicht unterscheiden, sondern das die Verbindungen 20 bis an die Außenseite des Kontakt-Abstandstransformers 4 verlaufen, sodass ihre Stirnflächen zur Berührungskontaktierung zur Verfügung stehen. Die Endabschnitte der Verbindungen 20 bilden dann die Kontakte 19. Selbstverständlich werden in den Figuren die noch nicht fertiggestellten Druckvorgänge solange weitergeführt, dass zum Abschluss erste Kontakte 16 gedruckt werden, die ebenso - wie erläutert - aufgebaut sein können und für eine Berührungskontaktierung zur Verfügung stehen. Die Figur 3 zeigt, dass elektrisch weniger leitfähiges Druckmaterial 63 zur Erzeugung eines elektrischen Widerstands 64 mittels des Dosierkopfs 60 zwischen zwei zweite Kontakte 19 platziert wurde. Mithin ist ein elektrisches Bauelement 59 in Form des erwähnten elektrischen Widerstands 64 geschaffen. Um als elektrische Bauelemente 59 Kondensatoren 65 zu schaffen, ist zwischen entsprechende zweite Kontakte 19 mittels der Dosierköpfe 61 und 62 entsprechendes Druckmaterial 66 und 67 gedruckt worden, wobei die Druckmaterialien 66 und 67 unterschiedliche Dielektrizitätskonstanten umfassen, wodurch die Größen der Kapazitäten der Kondensatoren beeinflusst werden. Sofern man mit elektrisch leitfähigem Druckmaterial 31 eine spiralförmige, schraubenförmige oder schneckenförmige Leiterstruktur druckt, schafft man als elektrische Bauelemente 59 Induktivitäten (nicht dargestellt). Selbstverständlich müssen die elektrischen Bauelemente 59 nicht - wie aus der Figur 3 ersichtlich - an der Außenseite platziert sein, sondern sie können auch in der Tragstruktur 28 eingebettet sein.

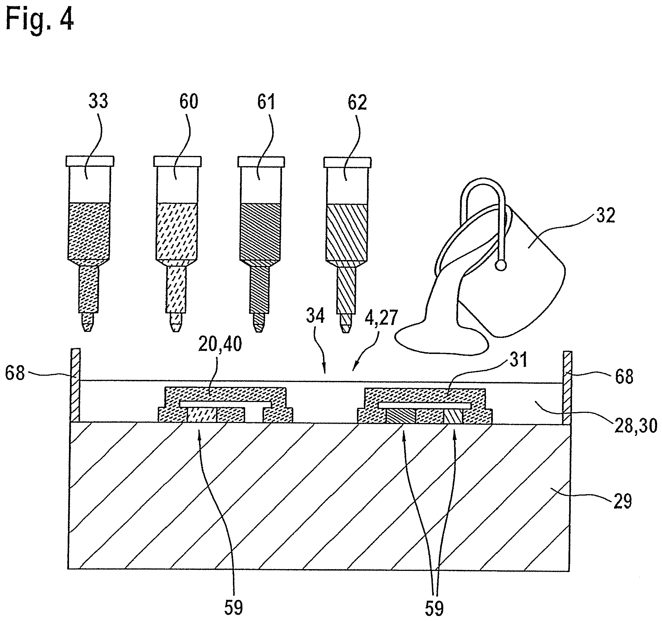

Die Figur 4 zeigt ein weiteres Ausführungsbeispiel bezüglich der Herstellung des Kontakt-Abstandstransformers 4 mittels 3D-Druckverfahren. Die Anordnung entspricht der Anordnung der Figur 3, sodass darauf verwiesen wird. Unterschiedlich ist lediglich, dass mittels eines sinnbildlich angedeuteten Dosierkopfes 32 Druckmaterial 30 "gedruckt" wird, das sehr dünnflüssig ist und sich infolge der Dünnflüssigkeit durch die Schwerkraft verteilt und auf diese Art und Weise zumindest Bereiche der Tragstruktur 28 geschaffen werden. Dieses dünnflüssige Druckmaterial 30 erstarrt selbstverständlich kurze Zeit nach seinem Drucken. Zur Vermeidung eines Wegfließens des Druckmaterials 30 sind seitlich der Druckstruktur Dichtwände 68 aufgebaut, die nur solange erforderlich sind, bis das Druckmaterial 30 ausgehärtet ist. Nach der Fertigstellung des 3D-gedruckten Kontakt-Abstandstransformer 4 wird dieser der wannenförmigen Stützstruktur (Unterlage 29 sowie Dichtwände 68) entnommen.

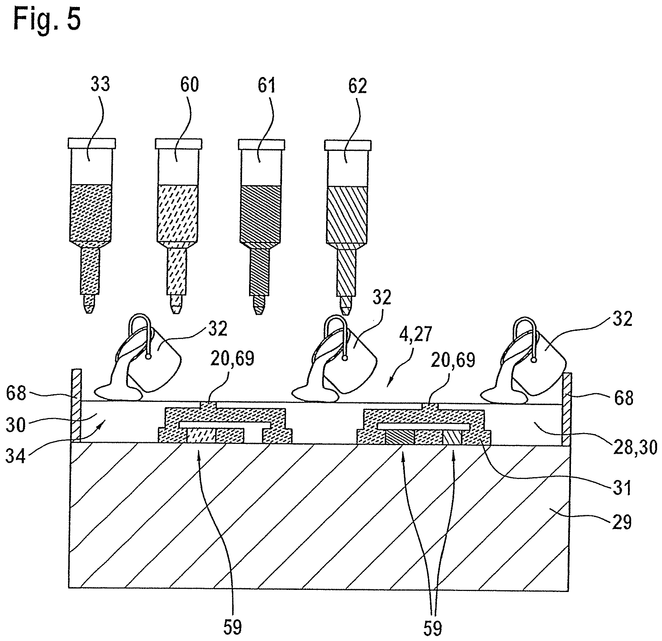

Die Figur 5 zeigt eine Ausgestaltung entsprechend der Figur 4, also das Drucken mit dünnflüssigem Druckmaterial 30 zur Erschaffung von elektrisch nicht leitenden Bereichen. Da - wie bereits erläutert - schichtweise das 3D-Drucken erfolgt, müssen möglicherweise abgetrennte Bereiche einzeln mittels dünnflüssigem Druckmaterial 30 aufgefüllt werden, um Abgrenzstrukturen 69, die im vorliegenden Falle von elektrischen Verbindungen 20 gebildet sind, zu überwinden. Insofern wird der Dosierkopf 32 nacheinander an drei verschiedenen Positionen eingesetzt, so wie dies in der Figur 5 angedeutet wird.

Insbesondere bei dünnflüssigem Druckmaterial 30 gemäß der Figuren 4 und 5 ist es denkbar, dass sich dieses Material an Strukturen, wie beispielsweise den Druckwänden 68 und den Abgrenzungsstrukturen 69, durch Kapillarwirkung "hochzieht", d.h., es gibt keine ebene Oberfläche, sondern randseitig Erhebungen. In einem solchen Falle ist es denkbar, diese Erhebungen durch Schleifen oder dergleichen in einem Zwischenschritt bei der Herstellung zu entfernen.

Ferner ist es - nach einer nicht dargestellten Weiterbildung der Erfindung - möglich, dass in das jeweilige Druckmaterial, beispielsweise in das nicht leitende Druckmaterial 30, Versteifungen eingebettet werden, um dem fertigen Produkt eine höhere Steifigkeit zu geben. Hierbei kann es sich beispielsweise um Versteifungsrippen oder Gitter und so weiter handeln. Diese Versteifungselemente werden durch das 3D-Drucken entsprechend eingebettet. Es ist natürlich auch möglich, die Versteifungselemente durch 3D-Drucken mit zu erstellen.

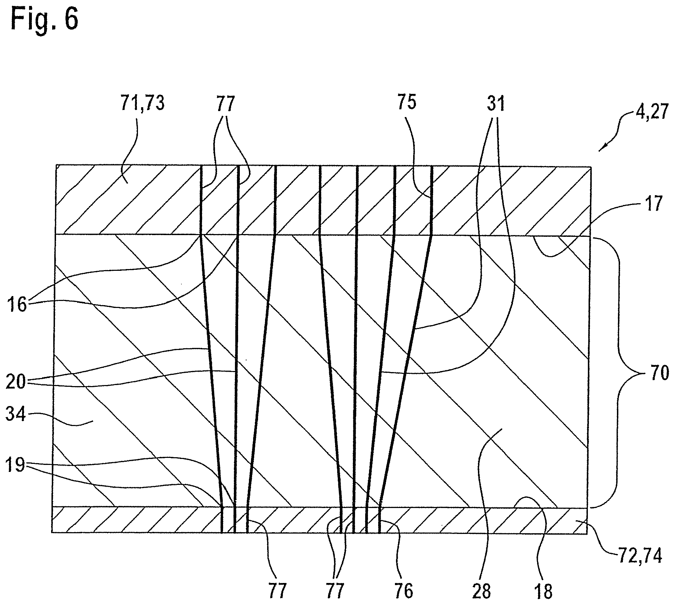

Die Figur 6 zeigt einen Kontakt-Abstandstransformer 4, der nur teilweise im 3D-Druckverfahren erstellt ist, nämlich nur der mit 70 gekennzeichnete Mittelbereich. Auf die erste Seite 17 und auf die zweite Seite 18 des Mittelbereichs 70 wurde ein Abschlusselement 71 beziehungsweise 72 befestigt, insbesondere durch Klebung befestigt. Bei dem Abschlusselement 70 handelt es sich um eine Keramikplatte 73, die mit mit spanabhebendem Werkzeug gebohrte Passbohrungen 75 versehen ist, wobei diese Passbohrungen den Kontaktabstand a aufweisen. Das Abschlusselement 72 ist ebenfalls eine Keramikplatte 74, die mit lasergebohrten Passbohrungen 76 versehen ist, wobei die einzelnen Passbohrungen 76 einen Kontaktabstand b voneinander aufweisen. Die Passbohrungen 75 und 76 sind mit Durchkontaktierungen 77 versehen, um elektrische Leiter zu erzeugen. Diese stehen mit den elektrischen Verbindungen 20 des komplett im 3D-Druck hergestellten Mittelbereichs 70 elektrisch in Verbindung. Dies kann beispielsweise durch thermisches Verbinden während des Herstellungsprozesses erfolgen. Thermische Verbindungen bedeutet, dass durch entsprechend hohe Temperatur eine Aktivierung der Materialien erfolgt, um die jeweiligen Durchkontaktierungen 77 mit den jeweiligen elektrischen Verbindungen 20 elektrisch zu kontaktieren. Insgesamt ist somit bei der Bauform des Kontakt-Abstandstransformers 4 der Figur 6 eine Sandwichbauweise realisiert.

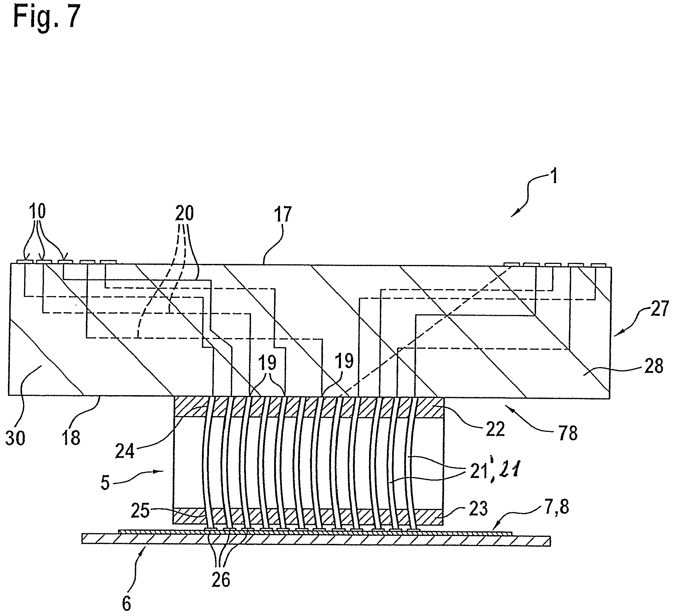

Die Figuren 7 bis 9 zeigen weitere Ausführungsformen der Erfindung, bei der Bauglieder der Prüfeinrichtung im 3D-Druckverfahren erstellt sind, wobei es sich bei den Baugliedern nicht nur um den Kontakt-Abstandstransformer 4, sondern auch um andere Bauglieder handeln kann, so wie dies nachstehend beispielhaft erläutert wird.

Die Figur 7 zeigt ein im 3D-Druck erstelltes Bauglied 78, das - im Vergleich mit der Figur 1 - das Leitersubstrat 2, das Verbindungsbauteil 3 und den Kontakt-Abstandstransformer 4 integrierend umfasst. Demzufolge sind auf der ersten Seite 17 des vorzugsweise komplett im 3D-Druck erstellten Bauglieds 78 die 3D-gedruckten Kontaktflächen 10 angeordnet, von denen elektrische Verbindungen 20 bis zur zweiten Seite 18 führen, an der die zweiten Kontakte 19 liegen, die mit dem Kontaktkopf 5 in Berührungskontaktierung stehen. Demzufolge nimmt das Bauglied 68 sowohl die Kontakt-Abstandstransformation des Leitersubstrats 2 als auch des Kontakt-Abstandstransformers 4 vor.

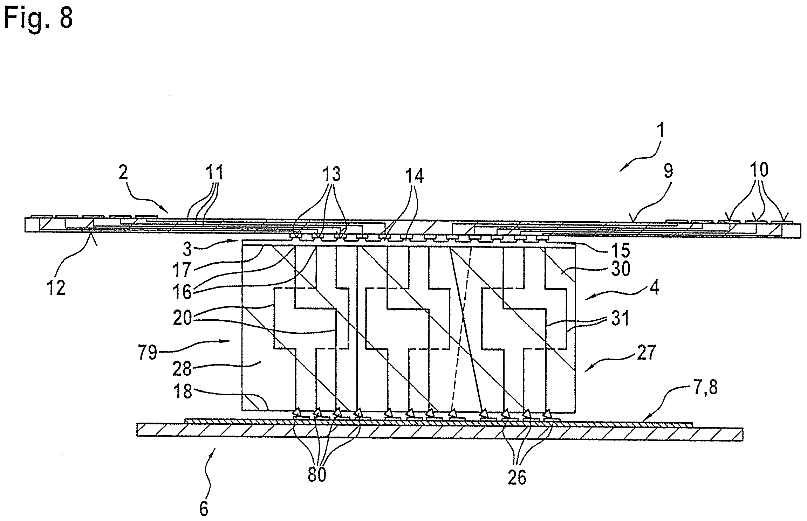

Das Ausführungsbeispiel der Figur 8 stellt ein Bauglied 79 vor, das im 3D-Druck erstellt ist und die Funktion des Kontakt-Abstandstransformers 4 und des Kontaktkopfs 5 integriert aufweist, indem - im Vergleich zu der Figur 1 - der Kontakt-Abstandstransformer 4 an seiner zweiten Seite 18 im 3D-Druck erhaben gedruckte Kontaktelemente 80 aufweist, die in Berührungskontaktierung mit den Prüflingskontakten 26 des Prüflings 7 bei dessen elektrischer Prüfung treten. Im Übrigen entspricht der Aufbau des Ausführungsbeispiels der Figur 8 dem Aufbau des Ausführungsbeispiels der Figur 1.

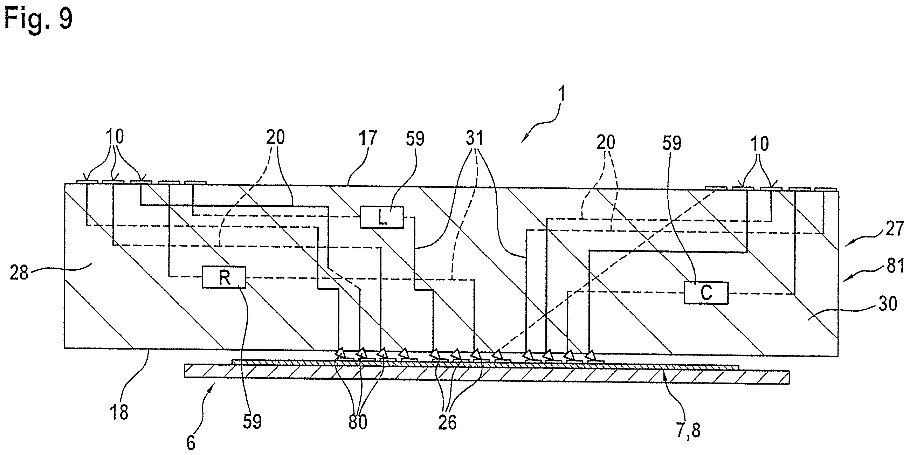

Die Figur 9 zeigt ein hochintegriertes Bauglied 81, das vorzugsweise komplett im 3D-Druck erstellt ist, und die Funktionen des Leitersubstrats 2, des Verbindungsbauteils 3, des Kontakt-Abstandstransformers 4 und des Kontaktkopfs 5 gemäß dem Ausführungsbeispiel der Figur 1 in sich integriert. Demzufolge sind auf der ersten Seite 17 die 3D-gedruckten Kontaktflächen 10 angeordnet und auf der zweiten Seite 18 erhabene Kontaktelemente 80, um dort den Prüfling 7 elektrisch durch Berührung kontaktieren zu können. Im Ausführungsbeispiel der Figur 9 sind in einigen Verbindungen 20 elektrische Bauelemente 59 durch 3D-Drucken integriert, nämlich elektrische Widerstände R, Spulen L sowie Kondensatoren C. Selbstverständlich können diese 3D-Druck-Bauelemente bei allen in den Figuren 1 bis 9 dargestellten Ausführungsbeispiele der Erfindung integriert sein.

Alle erwähnten Figuren 1 bis 9 können nur zweidimensionale Gebilde zeigen. Tatsächlich sind diese Gebilde natürlich dreidimensional ausgeführt.

## Patentansprüche

1. Kontakt-Abstandstransformer einer elektrischen Prüfeinrichtung zur Prüfung eines elektrischen Prüflings, insbesondere Wafers, wobei der Kontakt-Abstandstransformer zur Abstandsverkleinerung von benachbart zueinander liegenden elektrischen Kontakten dient und eine elektrisch nicht leitende Tragstruktur aufweist, die eine erste Seite und eine zweite Seite besitzt, wobei auf der ersten Seite erste elektrische Kontakte mit einem Kontaktabstand zueinander liegen und auf der zweiten Seite zweite elektrische Kontakte angeordnet sind, die einen gegenüber den ersten Kontakten der ersten Seite kleineren Kontaktabstand zueinander aufweisen, wobei die ersten Kontakte mit den zweiten Kontakten mittels die Tragstruktur durchsetzenden und/oder auf der Tragstruktur angeordneten elektrischen Verbindungen verbunden sind, **dadurch gekennzeichnet, dass** sowohl die Tragstruktur (28) als auch die elektrischen Verbindungen (20) als 3D-Druckbauteile (27) ausgebildet sind.

2. Kontakt-Abstandstransformer nach Anspruch 1, **dadurch gekennzeichnet, dass** die ersten und/oder die zweiten Kontakte (16,19) ebenfalls als 3D-Druckbauteile (27) ausgebildet sind.

3. Kontakt-Abstandstransformer nach einem der vorhergehenden Ansprüche, **dadurch gekennzeichnet, dass** mindestens ein erster und/oder mindestens ein zweiter Kontakt (16,19) durch die Stirnfläche mindestens einer der elektrischen Verbindungen (20) gebildet ist.

4. Kontakt-Abstandstransformer nach einem der vorhergehenden Ansprüche, **dadurch gekennzeichnet, dass** auf der ersten Seite (17) und/oder der zweiten Seite (18) ein Abschlusselement (71), insbesondere eine Abschlussplatte, bevorzugt eine Keramikplatte (73,74), angeordnet, insbesondere befestigt, ist, wobei das Abschlusselement (71) kein 3D-Druckbauteil ist.

5. Kontakt-Abstandstransformer nach einem der vorhergehenden Ansprüche, **dadurch gekennzeichnet, dass** das Abschlusselement (71) mit Durchgangskontakten, insbesondere Durchkontaktierungen (77), versehen ist, die mit den ersten oder zweiten Kontakten (16,19) elektrisch verbunden sind.

6. Elektrische Prüfeinrichtung zur Prüfung eines elektrischen Prüflings, insbesondere Wafers, **gekennzeichnet durch** einen Kontakt-Abstandstransformer (4) nach einem oder mehreren der vorhergehenden Ansprüche.

7. Elektrische Prüfeinrichtung nach Anspruch 6, mit einem Leitersubstrat (2), das Kontaktflächen (10) aufweist, die mit den ersten Kontakten (16) des Kontakt-Abstandstransformers (4) direkt oder über ein elektrisches Verbindungsbauteil (3) in elektrischer Verbindung, bevorzugt elektrischer Berührungsverbindung, stehen.

8. Elektrische Prüfeinrichtung nach einem der vorhergehenden Ansprüche, **dadurch gekennzeichnet, dass** der 3D-gedruckte Kontakt-Abstandstransformer (4) das 3D-gedruckte Leitersubstrat (2) mit ausbildet.

9. Elektrische Prüfeinrichtung nach einem der vorhergehenden Ansprüche, **dadurch gekennzeichnet, dass** die zweiten Kontakte (19) des Kontakt-Abstandstransformers (4) im 3D-Druck gedruckte, insbesondere erhaben gedruckte Kontaktelemente (80) zum direkten Berührungskontaktieren des Prüflings (7) sind.

10. Elektrische Prüfeinrichtung nach einem der vorhergehenden Ansprüche, **dadurch gekennzeichnet, dass** die Kontaktelemente (80) als punktförmige Kontakte, in Berührungskontaktierungsrichtung stiftförmige Kontakte oder größtenteils quer zur Berührungskontaktierungsrichtung verlaufende Kontakte, insbesondere Cantilever-Kontakte, ausgebildet sind.

11. Verfahren zur Herstellung eines Kontakt-Abstandstransformers (4) einer elektrischen Prüfeinrichtung (1) zur Prüfung eines elektrischen Prüflings (7), insbesondere Wafers (8), wobei der Kontakt-Abstandstransformer (4) insbesondere nach einem oder mehreren der vorhergehenden Ansprüche ausgebildet ist/wird, mit folgenden Schritten:
- 3D-Drucken, insbesondere schichtweises 3D-Drucken, von einer Tragstruktur (28) aus elektrisch isolierendem Druckmaterial (30) sowie
- 3D-Drucken, insbesondere schichtweises 3D-Drucken, von die Tragstruktur (28) durchsetzenden und/oder auf der Tragstruktur (28) angeordneten elektrischen Verbindungen (20) aus elektrisch leitfähigem Druckmaterial (31).

12. Verfahren nach Anspruch 11, **gekennzeichnet durch** 3D-Drucken, insbesondere schichtweises 3D-Drucken, von ersten und/oder zweiten Kontakten (16,19) aus elektrisch leitfähigem Druckmaterial (31), wobei die ersten und/oder zweiten Kontakte (16,19) an mindestens einem der Enden der elektrischen Verbindungen (20) angeordnet werden.

13. Verfahren nach einem der vorhergehenden Ansprüche, **gekennzeichnet durch** 3D-Drucken, insbesondere schichtweises 3D-Drucken, von elektrisch leitfähigem Druckmaterial (31) auf zuvor 3D-gedrucktem elektrisch isolierenden Druckmaterial (30), insbesondere zur Herstellung von elektrischen Querverbindungen (40).

14. Verfahren nach einem der vorhergehenden Ansprüche, **gekennzeichnet durch** 3D-Drucken, insbesondere schichtweises 3D-Drucken, von elektrisch weniger leitfähigem Druckmaterial (63) zur Herstellung von mindestens einem elektrischen Widerstand (64,R).

15. Verfahren nach einem der vorhergehenden Ansprüche, **gekennzeichnet durch** 3D-Drucken, insbesondere schichtweises 3D-Drucken, von sich gegenüberliegenden Elektroden aus elektrisch leitfähigem Druckmaterial (31) zur Herstellung eines Kondensators (65,C), wobei vorzugsweise ein 3D-Druck von Dielektrikummaterial (66,67) zwischen die Elektroden erfolgt.

16. Verfahren nach einem der vorhergehenden Ansprüche, **gekennzeichnet durch** 3D-Drucken, insbesondere schichtweises 3D-Drucken (31), von spiralförmigen und/oder schneckenförmigen und/oder wendelförmigen Leitern aus elektrisch leitfähigem Material zur Herstellung von mindestens einer Spule (L).

17. Verfahren nach einem der vorhergehenden Ansprüche, **gekennzeichnet durch** 3D-Drucken, insbesondere schichtweises 3D-Drucken, von flüssiger, sich unter Schwerkrafteinwirkung verteilender und danach aushärtender Isolierflüssigkeit (30) zur Herstellung von elektrischen Isolationsbereichen, insbesondere Isolationsschichten, vorzugsweise von Bereichen der Tragstruktur (28).

## Claims

1. A contact-distance transformer of an electric testing device for testing an electric specimen, in particular a wafer, wherein said contact-distance transformer is used to reduce the distance between neighbouring electric contacts, and is provided with a non-electrically conductive supporting structure, which is provided with a first side and a second side, wherein on the first side first electric contacts are positioned at a contact distance to each other, and on the second side second electric contacts are positioned, which have a contact distance to each other which is smaller than the contact distance of the first contacts on the first side, wherein the first contacts are connected to the second contacts by means of electric connections which pass through the support structure and/or which are positioned on the support structure, **characterized in that** both the support structure (28) and the electric connections (20) are formed as 3D-printed components (27).

2. The contact-distance transformer according to claim 1, **characterized in that** the first and/or second contacts (16, 19) are also formed as 3D-printed components (27).

3. The contact-distance transformer according to any of the preceding claims, **characterized in that** at least a first and/or at least a second contact (16, 19) are formed by the front surface of at least one of the electric connections (20).

4. The contact-distance transformer according to any of the preceding claims, **characterized in that** on the first side (17) and/or on the second side (18) a terminal element (71), in particular a terminal plate, preferably a ceramic plate (73, 74), is positioned, in particular attached, wherein the terminal element (71) is not a 3D-printed component.

5. The contact-distance transformer according to any of the preceding claims, **characterized in that** the terminal element (71) is provided with through contacts, in particular through-hole platings (77), which are electrically connected to the first or second contacts (16, 19).

6. An electric testing device for testing an electric specimen, in particular a wafer, **characterized by** a contact-distance transformer (4) according to one or more of the preceding claims.

7. The electric testing device according to claim 6, with a conductive substrate (2), which comprises contact surfaces (10), which are electrically connected, preferably through an electric physical connection, directly or through an electric connection component (3) to the first contacts (16) of the contact-distance transformer (4).

8. The electric testing device according to any of the preceding claims, **characterized in that** the 3D-printed contact-distance transformer (4) contributes to forming the 3D-printed conductive substrate (2).

9. The electric testing device according to any of the preceding claims, **characterized in that** the second contacts (19) of the contact-distance transformer (4) are 3D-printed contact elements (80), in particular printed in a raised manner, for direct physical contact of the specimen (7).

10. The electric testing device according to any of the preceding claims, **characterized in that** the contact elements (80) are formed as point-like contacts, pin-like contacts directed in the direction of physical contact or contacts that predominantly extend transversely with respect to the direction of physical contact, in particular cantilever contacts.

11. A method for producing a contact-distance transformer (4) of an electric testing device (1) for testing an electric specimen (7), in particular a wafer (8), wherein the contact-distance transformer (4) is provided in particular according to one or more of the preceding claims, with following steps:
- 3D-printing, in particular layer-by-layer 3D-printing, of a supporting structure (28) of electric insulating printing material (30), and
- 3D-printing, in particular layer-by-layer 3D-printing, of electric connections (20), which pass through the supporting structure (28) and/or are positioned on the supporting structure (28), the electric connections being printed of electrically conductive printing material (31).

12. The method according to claim 11, **characterized by** 3D-printing, in particular layer-by-layer 3D-printing, of first and/or second contacts (16, 19) of electrically conductive printing material (31), wherein the first and/or second contacts (16, 19) are positioned on at least one of the ends of the electric connections (20).

13. The method according to any of the preceding claims, **characterized by** 3D-printing, in particular layer-by-layer 3D-printing, of electrically conductive printing material (31) on previously 3D-printed electrically insulating printing material (30), in particular for producing electric transverse connections (40).

14. The method according to any of the preceding claims, **characterized by** 3D-printing, in particular layer-by-layer 3D-printing, of electrically less conductive printing material (63) for producing at least one electric resistor (64, R).

15. The method according to any of the preceding claims, **characterized by** 3D-printing, in particular layer-by-layer 3D-printing, of mutually opposed electrodes of electrically conductive printing material (31) for producing a capacitor (65, C), wherein preferably a 3D-printing of dielectric material (66, 67) takes place between the electrodes.

16. The method according to any of the preceding claims, **characterized by** 3D-printing, in particular layer-by-layer 3D-printing, of spiral and/or helical and/or coil-shaped conductors of electrically conductive material, for producing at least one coil (L).

17. The method according to any of the preceding claims, **characterized by** 3D-printing, in particular layer-by-layer 3D-printing, of liquid insulating liquid (30), which diffuses under the influence of gravity and then hardens, for producing electric insulating areas, in particular insulating layers, preferably of areas of the supporting structure (28).

## Revendications

1. Intercalaire de contact d'un dispositif d'essai électrique pour le contrôle électrique d'un objet d'essai électrique, en particulier d'une plaquette, l'intercalaire de contact servant pour la réduction de la distance des contacts électriques adjacents, et ayant une structure de support électriquement non-conductrice avec un premier côté et un second côté, avec des contacts électriques premiers ayant une distance de contact entre eux sur le premier côté, et des contacts électriques seconds disposés sur le second côté et ayant une distance de contact entre eux qui est inférieure à celle des premiers contacts sur le premier côté, les premiers contacts étant reliés aux seconds contacts au moyen des connexions électriques qui pénètrent la structure de support et/ou sont arrangées sur la structure de support, **caractérisé en ce que** soit la structure de support (28) soit les connexions électriques (20) sont configurées sous forme de composants électroniques imprimés en 3D (27).

2. Intercalaire de contact selon la revendication 1, **caractérisé en ce que** les premiers et/ou les seconds contacts (16, 19) sont aussi configurés sous forme de composants électroniques imprimés en 3D (27).

3. Intercalaire de contact selon l'une quelconque des revendications précédentes, **caractérisé en ce qu'**au moins un premier et/ou au moins un second contact (16, 19) est/sont formé(s) par la face frontale d'au moins une des connexions électriques (20).

4. Intercalaire de contact selon l'une quelconque des revendications précédentes, **caractérisé en ce qu'**un élément de terminaison (71), notamment une plaque de terminaison, de préférence une plaque céramique (73, 74), est arrangé, notamment fixé, sur le premier côté (17) et/ou le second côté (18), l'élément de fermeture (71) n'étant pas de composant imprimé en 3D.

5. Intercalaire de contact selon l'une quelconque des revendications précédentes, **caractérisé en ce que** l'élément de terminaison (71) est muni des contacts traversants, notamment des vias (77), qui sont reliés électriquement aux premiers et seconds contacts (16, 19).

6. Dispositif d'essai électrique pour le contrôle électrique d'un objet d'essai électrique, en particulier une plaquette, **caractérisé par** un intercalaire de contact (4) selon l'une ou plusieurs des revendications précédentes.

7. Dispositif d'essai électrique selon la revendication 6, avec un substrat conducteur (2) ayant des surfaces de contact (10) qui sont en connexion électrique, de préférence en connexion par contact électrique, avec les premiers contacts (16) d'intercalaire de contact (4) soit directement soit par l'intermédiaire d'un composant de connexion électrique (3).

8. Dispositif d'essai électrique selon l'une quelconque des revendications précédentes, **caractérisé en ce que** l'intercalaire de contact (4) imprimé en 3D forme aussi le substrat conducteur (2) imprimé en 3D.

9. Dispositif d'essai électrique selon l'une quelconque des revendications précédentes, **caractérisé en ce que** les seconds contacts (19) de l'intercalaire de contact (4) sont des éléments de contact (80) imprimés en 3D, notamment imprimés en relief, pour la connexion directe par contact de l'objet d'essai (7).

10. Dispositif d'essai électrique selon l'une quelconque des revendications précédentes, **caractérisé en ce que** les éléments de contact (80) sont configurés sous forme des contacts à pointe, sous forme des broches dans la direction de connexion par contact, ou sous forme de contacts s'étendant pour la plupart transversalement à la direction de connexion par contact, notamment sous forme de contacts à cantilever.

11. Procédé pour la fabrication d'un intercalaire de contact (4) d'un dispositif d'essai électrique (1) pour le contrôle électrique d'un objet d'essai électrique (7), notamment d'une plaquette (8), l'intercalaire de contact (4) étant configuré notamment selon l'une ou plusieurs des revendications précédentes, le procédé comprenant les étapes consistant à :
- imprimer en 3D, notamment imprimer en 3D par couches, une structure de support (28) en matériau d'impression électriquement isolant (30), et
- imprimer en 3D, notamment imprimer en 3D par couches, des connexions électriques (20) pénétrant la structure de support (28) et/ou étant arrangées sur la structure de support (28), en matériau d'impression conducteur de l'électricité (31).

12. Procédé selon la revendication 11, **caractérisé par** l'étape consistant à imprimer en 3D, notamment imprimer en 3D par couches, des premiers et/ou seconds contacts (16, 19) en matériau d'impression conducteur de l'électricité (31), les premiers et/ou seconds contacts (16, 19) étant disposés sur au moins une des extrémités des connexions électriques (20).

13. Procédé selon l'une quelconque des revendications précédentes, **caractérisé par** l'étape consistant à imprimer en 3D, notamment imprimer en 3D par couches, d'un matériau d'impression conducteur de l'électricité (31) sur un matériau d'impression électriquement isolant (30) préalablement imprimé en 3D, notamment pour la fabrication des interconnexions électriques (40).

14. Procédé selon l'une quelconque des revendications précédentes, **caractérisé par** l'étape consistant à imprimer en 3D, notamment imprimer en 3D par couches, d'un matériau d'impression (63) avec une conductivité électrique plus faible, pour fabriquer au moins une résistance électrique (64, R).

15. Procédé selon l'une quelconque des revendications précédentes, **caractérisé par** l'étape consistant à imprimer en 3D, notamment imprimer en 3D par couches, des électrodes opposées en matériau d'impression conducteur de l'électricité (31), pour fabriquer un condensateur (65, C), en effectuant de préférence une impression en 3D du matériau diélectrique (66, 67) entre les électrodes.

16. Procédé selon l'une quelconque des revendications précédentes, **caractérisé par** l'étape consistant à imprimer en 3D, notamment imprimer en 3D par couches (31), des conducteurs spiralés et/ou hélicoïdaux et/ou tortueux en matériau conducteur de l'électricité, pour fabriquer au moins une bobine (L).

17. Procédé selon l'une quelconque des revendications précédentes, **caractérisé par** l'étape consistant à imprimer en 3D, notamment imprimer en 3D par couches, d'un liquide isolant (30) qui se répartit sous l'influence de la gravité et durcit ensuite, pour fabriquer des régions électriquement isolantes, notamment des couches isolantes, de préférence des régions de la structure de support (28).
